# EUROPEAN PATENT APPLICATION

(11) **EP 3 258 683 A1**
(43) Date of publication of application: **20.12.2017**
(21) Application number: 16174188.9
(22) Date of filing: 13.06.2016
(51) Int. Cl.: H04N 5/355, H04N 5/3745, H04N 5/347

(54) **IMAGE SENSOR AND METHOD FOR OPERATING AN IMAGE SENSOR**

(71) Applicant: ams AG, 8141 Unterpremstätten (AT)
(72) Inventor: WOLFS, Bram, 3221 Nieuwrode (BE); BLANCHAERT, Tim, 2440 Geel (BE)
(74) Representative: Epping - Hermann - Fischer

(57) **Abstract**

An image sensor (10) comprises an array of pixels (11) having a subset of pixels (12). The subset of pixels (12) comprises a first and a second pixel (20, 30), wherein the first and the second pixel (20, 30) each comprises a pinned photodiode (21, 31), a sense node (22, 32), a transfer gate (23, 33) coupled to the pinned photodiode (21, 31) and the sense node (22, 32), and a connection switch (24, 34) coupled to the sense node (22, 32). The subset of pixels (12) further comprises a common reset node (40) such that the connection switch (24, 34) of the first and the second pixel (20, 30) are coupled to the common reset node (40), and a single reset transistor (41) providing a reset voltage (VRES) to the common reset node (40). The first and the second pixel (20, 30) share the single reset transistor (41).

## Description

The present patent application is related to an image sensor and to a method for operating an image sensor.

An image sensor comprises pixels arranged in an array of rows and columns. Each pixel comprises a photodiode having a junction capacitance that is discharged by a photocurrent generated by the received light in a collecting phase. At the end of the collecting phase, the charge collected by the photodiode is transferred to a sense node. After that the pixel is reset by recharging the photodiode in a reset phase.

It is an object of the present patent application to provide an image sensor and a method for operating an image sensor realizing a reset of a photodiode with a reduced number of devices.

This object is solved by the subject-matter of the independent claims. Further developments and embodiments are described in the dependent claims.

In an embodiment, an image sensor comprises an array of pixels having at least a subset of pixels. The subset of pixels comprises a first and a second pixel. Each of the first and the second pixel comprises: a pinned photodiode, a sense node, a transfer gate coupled to the pinned photodiode and coupled to the sense node, and a connection switch coupled to the sense node. The subset of pixels further comprises a common reset node such that the connection switch of the first pixel is coupled to the common reset node and the connection switch of the second pixel is coupled to the common reset node. Additionally, the subset of pixels comprises a single reset transistor which is configured to provide a reset voltage to the common reset node. The first and the second pixel share the single reset transistor.

Advantageously, only one transistor provides the reset voltage to the common reset node, namely the single reset transistor. Thus, the number of transistors comprised by the subset of pixels is reduced. By reducing the number of devices and control lines to operate the pixels, especially to reset the pixels, a high fill factor may be achieved.

In an embodiment, the maximum number of one single reset transistor provides the reset voltage to the common reset node.

In an embodiment, the only controlled sections that are directly connected to the common reset node are the controlled sections of the single reset transistor and of the connection switches of the first and the second pixel.

In a further development, the subset of pixels comprises at least a third pixel. The at least third pixel comprises a connection switch. The only controlled sections that are directly connected to the common reset node are the controlled sections of the single reset transistor and of the connection switches of the first and the second pixel and of the at least third pixel.

In an embodiment, the array of pixels comprises an output bus and a supply line. Each of the first and the second pixel comprises a source follower transistor having a gate connected to the sense node, a first terminal coupled to the output bus and a second terminal coupled to the supply line.

In an embodiment, each of the first and the second pixel comprises a select transistor coupling the first terminal of the source follower transistor to the output bus.

In an embodiment, the array of pixels comprises a reset control line. The single reset transistor comprises a control terminal connected to the reset control line. The control terminal of the single reset transistor may be the only control terminal comprised by the subset of pixels that is connected to the reset control line.

In an embodiment, the control terminal of the single reset transistor is the only control terminal comprised by the subset of pixels that receives a reset control signal.

In an embodiment, the controlled section of the single reset transistor comprises a first terminal coupled to the common reset node and a second terminal coupled to one of a group comprising a reset bus, an output bus and a supply line.

In an embodiment, the subset of pixels is free of a transistor, switch or gate coupling and/or having a controlled section with a first terminal directly connected to the common reset node and a second terminal directly connected to one of a group consisting of a reset bus, an output bus, a supply line and/or a connection line connecting two common reset nodes of two different subsets of pixels besides the single reset transistor.

In an embodiment, the sense nodes of the first and the second pixel and the common reset node are realized as three separated floating diffusion sense nodes.

In an embodiment, each of the first and the second pixel comprises a global shutter gate arranged between the pinned photodiode and the transfer gate.

In an embodiment, each of the first and the second pixel comprises an anti-blooming gate coupled to the pinned photodiode.

In an embodiment, the image sensor is configured to read out the first pixel with at least two different conversion gains.

In an embodiment, the image sensor is configured to read out the first pixel with multiple conversion gains.

In an embodiment, the number of different conversion gains may be two, three, four, five or more than five.

In an embodiment, in a first conversion gain, only the sense node of the first pixel receives a charge collected by the pinned photodiode of the first pixel.

In an embodiment, in a second conversion gain, only the sense node of the first pixel and the common reset node may receive the charge collected by the pinned photodiode of the first pixel.

In an embodiment, in a third conversion gain, the sense node of the first pixel, the common reset node and the sense node of the second pixel receive the charge collected by the pinned photodiode of the first pixel.

In an embodiment, in a conversion gain, the sense node of the first pixel, the common reset node and the sense node or sense nodes of at least a further pixel receive the charge collected by the pinned photodiode of the first pixel.

In an embodiment, the image sensor is configured to read out the second pixel with at least two different conversion gains.

The conversion gain of the second pixel may be set in a manner corresponding to the first pixel.

In an embodiment, the subset of pixels comprises a third and a fourth pixel, each comprising a pinned photodiode and a transfer gate. The conversion gain of the third and the fourth pixel may be set in a manner corresponding to the first pixel.

In a further development, each of the third and the fourth pixel comprises a sense node and a connection switch. The transfer gate of the third pixel couples the pinned photodiode of the third pixel to the sense node of the third pixel. The connection switch of the third pixel couples and/or connects the sense node of the third pixel to the common reset node. The transfer gate of the fourth pixel couples the pinned photodiode of the fourth pixel to the sense node of the fourth pixel. The connection switch of the fourth pixel couples and/or connects the sense node of the fourth pixel to the common reset node.

In a further development, the subset of pixels comprises the third pixel, wherein the transfer gate of the third pixel couples the pinned photodiode of the third pixel to the sense node of the first pixel. The subset of pixels comprises the fourth pixel, wherein the transfer gate of the fourth pixel couples the pinned photodiode of the fourth pixel to the sense node of the second pixel.

Each pixel of the subset of pixels may share the single reset transistor. Thus, the single reset transistor may be shared by the first to the fourth pixel.

The image sensor may realize a pixel sharing architecture for a two-dimensional imaging array. Advantageously, the number of control signals and transistors needed to control and read out the pixel array is minimized while keeping large functionality (gain, noise reduction, in-pixel binning for mono and colorized arrays). This reduction allows further pixel down-scaling with optimal area efficiency needed to optimize other specifications like full well charge, quantum efficiency and/or angular response.

The single reset transistor is shared per group of pixels such as a subset of pixels. A pixel select transistor may optionally be designed or removed. Row selection is done through reset switches, select transistors and output busses. The output busses are realized as column busses. The pixel architecture allows binning of multiple pixels in multiple binning schemes in the pixel. The single reset transistor can be named single reset switch.

The image sensor has the ability to switch the conversion gain. Less devices per pixel allows to: Scale down pixel size, increase optical active area per pixel and/or increase charge storage capacity per pixel. Binning in the pixel may reduce readout time for a binned readout mode. A single row access period may be sufficient to bin pixel signals of two rows.

In an embodiment, the pinned photodiode comprises a buried signal charge storage well region of a first conduction type sandwiched between a lower layer of a second conduction type and a highly doped pinning layer of the second conduction type at a top surface of a semiconductor substrate of a semiconductor body. The highly doped pinning layer may be in contact with the lower layer. The first conduction type may be n-type and the second conduction type may be p-type. The pinned photodiode can be built using a p on p+ epi substrate, or implemented by a p-well in an n on n+ epi substrate. Alternatively, the first conduction type may be p-type and the second conduction type may be n-type.

Advantageously, the pinned photodiode has a lower noise, higher quantum efficiency and lower dark current in comparison to a standard photodiode or a pin photodiode.

In an embodiment, a method for operating an image sensor comprises to reset a sense node of a first pixel and to reset a sense node of a second pixel by switching a connection switch of the first pixel, a connection switch of the second pixel and a single reset transistor in a conducting state and providing a reset voltage to a common reset node by the single reset transistor. Each of the first and the second pixel comprises a pinned photodiode and a transfer gate coupled to the pinned photodiode and to the sense node. The connection switch of the first pixel couples the common reset node to the sense node of the first pixel. The connection switch of the second pixel couples the common reset node to the sense node of the second pixel. The single reset transistor is coupled to the common reset node. The single reset transistor is shared by the first and the second pixel.

Advantageously, the single reset transistor is shared by the first and the second pixel such that an area on a semiconductor body on which the image sensor is fabricated can be efficiently used to improve pixel performance.

The following description of figures of exemplary embodiments may further illustrate and explain aspects of the invention. Devices and circuit parts with the same structure and the same effect, respectively, appear with equivalent reference symbols. In so far as devices or circuit parts correspond to one another in terms of their function in different figures, the description thereof is not repeated for each of the following figures.
- Figure 1: show an exemplary embodiment of an image sensor with a first and a second pixel.
- Figures 2 to 6: show further exemplary embodiments of an image sensor with a first and a second pixel and an anti-blooming gate.
- Figures 7 to 9: show further exemplary embodiments of an image sensor with four pixels.
- Figure 10: shows an additional exemplary embodiment of an image sensor.

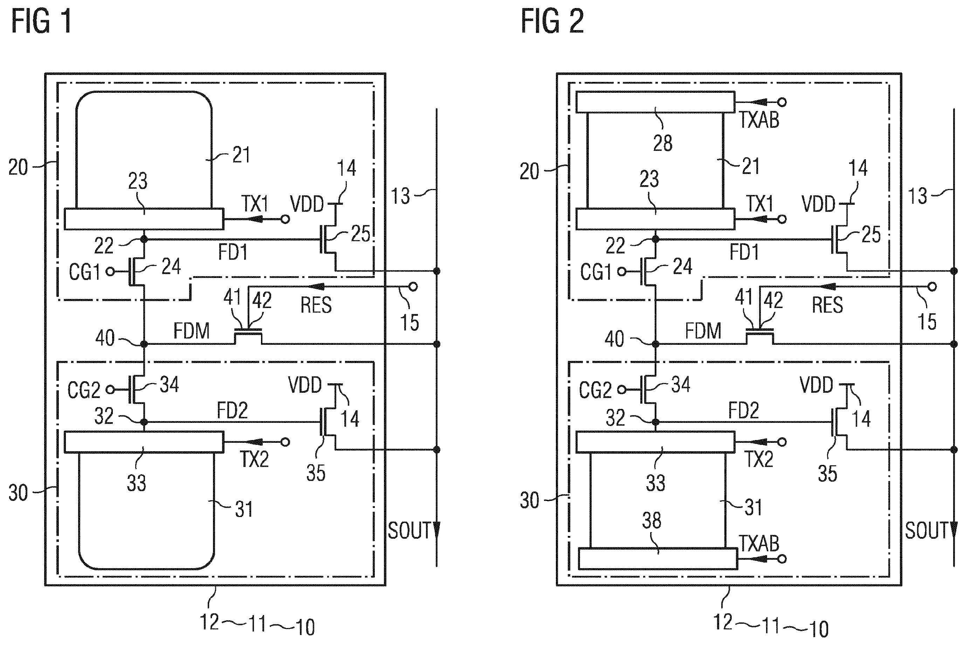

Figure 1 shows an exemplary embodiment of an image sensor 10 comprising an array of pixels 11. The array of pixels comprises subsets of pixels. In Figure 1, one subset of pixels 12 is shown. Moreover, the array of pixels 11 comprises an output bus 13. Additionally, the array of pixels 11 comprises a supply line 14.

The subset of pixels 12 comprises a first and a second pixel 20, 30. The first and the second pixel 20, 30 are identical. The first and the second pixel 20, 30 each comprises a pinned photodiode 21, 31, a sense node 22, 32 and a transfer gate 23, 33. The transfer gate 23 of the first pixel 20 couples the pinned photodiode 21 of the first pixel 20 to the sense node 22 of the first pixel 20. Correspondingly, in the second pixel 30, the transfer gate 33 couples the pinned photodiode 31 to the sense node 32.

The first pixel 20 comprises a connection switch 24 that couples the sense node 22 of the first pixel 20 to a common reset node 40 of the subset of pixels 12. Similarly, the second pixel 30 comprises a connection switch 34 that couples the sense node 32 of the second pixel 30 to the common reset node 40.

The first pixel 20 further comprises a source follower transistor 25 having a control terminal coupled to the sense node 22 of the first pixel 20. A first terminal of the source follower transistor 25 is coupled to the output bus 13. A second terminal of the source follower transistor 25 is coupled to the supply line 14.

Correspondingly, the second pixel 30 comprises a source follower transistor 35 having a control terminal coupled to the sense node 32 of the second pixel 30. A first terminal of the source follower transistor 35 is coupled to the output bus 13. A second terminal of the source follower transistor 35 is coupled to the supply line 14.

The subset of pixels 12 comprises a single reset transistor 41 having a first terminal coupled to the common reset node 40. A second terminal of the single reset transistor 41 may be coupled to the output bus 13. A control terminal 42 of the single reset transistor 41 is connected to a reset control line 15 of the array of pixels 11.

Thus, the first terminal of the single reset transistor 41 may be directly and permanently connected to the common reset node 40. The second terminal of the single reset transistor 41 may be directly and permanently connected to the output bus 13.

The reset control line 15 provides a reset control signal RES to the control terminal 42 of the single reset transistor 41. The image sensor 10 provides a first connection signal CG1 to a control terminal of the connection switch 24 of the first pixel 20 and a second connection signal CG2 to a control terminal of the connection switch 34 of the second pixel 30.

In a reset phase, the single reset transistor 41 is set in a conducting state by the reset control signal RES and the connection switches 24, 34 of the first and second pixel 20, 30 are also set in a conducting state by the first and the second connection signals CG1, CG2. A reset voltage VRES is provided to the output bus 13 in the reset phase. The reset voltage VRES may be equal to the supply voltage VDD. The reset voltage VRES is provided via the single reset transistor 41 to the common reset node 40 and therefore via the connection switches 24, 34 of the first and the second pixel 20, 30 also to the sense nodes 22, 32 of the first and the second pixel 20, 30. Thus, the two sense nodes 22, 32 and the common reset node 40 are reset by exactly three transistors, namely the single reset transistor 41 and the connection switches 24, 34 of the first and the second pixel 20, 30. The reset of the sense nodes 22, 32 of the first and the second pixel 20, 30 is performed in the reset phase. The reset of the common reset node 40 is performed via the controlled section of the single reset transistor 41 in the reset phase.

The subset of pixels 12 and/or the array of pixels 11 are free from any further transistor, gate or switch providing any voltage to the common reset node 40 and/or to the sense nodes 22, 32 of the first and the second pixel 20, 30 in the reset phase besides the single reset transistor 41.

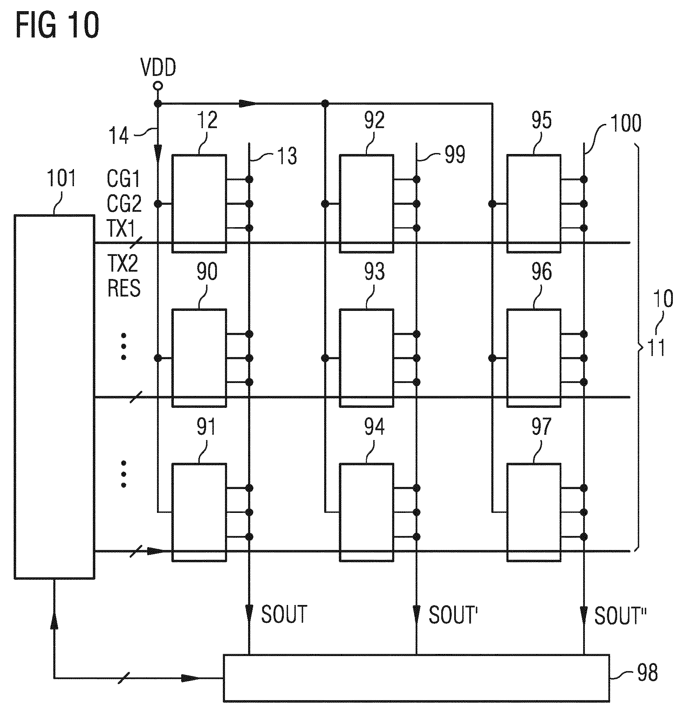

At the end of the reset phase, the reset voltage VRES is no longer applied to the output bus 13. Instead a bias current is applied to the output bus 13. An output signal SOUT can be detected at the output bus 13. The output signal SOUT drops to a reset value that is sampled by a readout structure 98 of the image sensor 10 shown in Figure 10.

In or after an integration phase or imaging phase that follows the reset phase, the transfer gate 23 of the first pixel 20 is set in a conducting state by a first transfer signal TX1 such that a charge collected by the pinned photodiode 21 of the first pixel 20 is provided to the sense node 22 of the first pixel 20. The collected charge at the sense node 22 results in a first sense node signal FD1 provided to the control terminal of the source follower transistor 25 of the first pixel 20. The first sense node signal FD1 is implemented as a voltage. The supply line 14 applies a supply voltage VDD to the second terminal of the source follower transistor 25. The output signal SOUT at the output bus 13 is a function of the supply voltage VDD and of the first sense node signal FD1 provided to the control terminal of the source follower transistor 25. The output signal SOUT at the output bus 13 is further evaluated by the image sensor 10, namely by the readout structure 98 of the image sensor 10. The output signal SOUT may have the form of a voltage.

In the integration phase or imaging phase, the single reset transistor 41 is set in a non-conducting state by the reset control signal RES.

Since the charge collected by the pinned photodiode 21 of the first pixel 20 is only provided to the sense node 22 of the first pixel 20, a first conversion gain that is also called high conversion gain is achieved. The connection switches 24, 34 of the first and the second pixel 20, 30 are set in a non-conducting state by the first and second connection signals CG1, CG2 to realize the first conversion gain.

To achieve a second conversion gain, the charge collected by the pinned photodiode 21 of the first pixel 20 is provided to the sense node 22 of the first pixel 20 and to the common reset node 40 by setting the transfer gate 23 of the first pixel 20 and the connection switch 24 of the first pixel 20 in a conducting state. The second conversion gain is lower than the first conversion gain and may be called medium conversion gain. The single reset transistor 41 is set in the non-conducting state by the reset control signal RES and the connection switch 34 of the second pixel 30 is also set in the non-conducting state by the second connection signal CG2.

Thus, for realization of the second conversion gain, the collected charge is provided to two capacitors that are realized by the sense node 22 of the first pixel 20 and by the common reset node 40. The first sense node signal FD1 is provided to the control terminal of the source follower transistor 25 of the first pixel 20 which generates the output signal SOUT at the output bus 13.

To realize a third conversion gain, the charge collected by the pinned photodiode 21 of the first pixel 20 is provided to the sense node 22 of the first pixel 20, to the common reset node 40 and to the sense node 32 of the second pixel 30. The third conversion gain is smaller than the second conversion gain and may be named low conversion gain. The third conversion gain is achieved by setting the connection switches 24, 34 of the first and the second pixel 20, 30 and the transfer gate 23 of the first pixel 20 in a conducting state. The single reset transistor 41 is set in the non-conducting state by the reset control signal RES. Thus, the collected charge is applied to three capacitors that are switched in parallel. The resulting first sense node signal FD1 is provided to the control terminal of the source follower transistor 25 that generates the output signal SOUT at the output bus 13. The first, the second and the third conversion gains are different.

The second pixel 30 can be operated in a manner corresponding to the first pixel 20.

Advantageously, only one reset transistor, namely the single reset transistor 41 is necessary to provide a reset to two pixels 20, 30. The single reset transistor 41 is shared between the first and the second pixel 20, 30. Thus, an area on a semiconductor body required for the realization of the subset of pixels 12 is reduced. In case an area for the subset of pixels 12 is predetermined, the area of the two pinned photodiodes 21, 31 can be increased by the use of only one single reset transistor 41, achieving a high fill factor.

In Figure 1, the image sensor 10 is implemented by a 2x1 shared rolling shutter pixel architecture without anti-blooming gate. Anti-blooming (draining of excess charges collected in the pinned photodiode 21, 31) can be performed through the two connection switches 24, 34 and the single reset transistor 41 by setting the low levels of the two connection signals CG1, CG2 and the reset control signal RES such that charges can be drained before blooming occurs. The same adaptation is possible to the embodiments shown in Figure 2 to 5, 7 and 9 (all rolling shutter variants).

Advantageously, the number of transistors and gates for providing the output signal SOUT to the output bus 13 and for resetting the two pixels 20, 30 is very small. The first and the second pixel 20, 30 shown in Figure 1 are free from an anti-blooming gate, a global shutter gate, a select transistor and a select line.

Figure 2 shows a further exemplary embodiment of the image sensor 10 which is a further development of the embodiment shown in Figure 1. The first pixel 20 comprises an anti-blooming gate 28 that is connected to the pinned photodiode 21 of the first pixel 20. Correspondingly, the second pixel 30 comprises an anti-blooming gate 38 that is connected to the pinned photodiode 31 of the second pixel 30. The anti-blooming gates 28, 38 of the first and the second pixel 20, 30 are both controlled by an anti-blooming signal TXAB that is provided by the image sensor 10. Advantageously, in the case of a high illumination, excess charges can be removed from the pinned photodiodes 21, 31 by the anti-blooming gates 28, 38.

In Figure 2, the image sensor 10 is configured as a 2x1 shared rolling shutter pixel architecture. The image sensor 10 realizes a rolling shutter variant of a 2:1 sharing architecture. A global reset operation of the photodiodes 21, 31 is performed by row-by-row or global reset by enabling the transfer gates 23, 33 together with the connection switches 24, 34 and the single reset transistor 41, while the output bus 13 is at the level of the supply voltage VDD. Figure 1 shows an embodiment of the structure shown in Figure 2, where the anti-blooming gate 28, 38 is left out.

The first and the second pixel 20, 30 shown in Figure 2 are free from a global shutter gate, a select transistor and a select line.

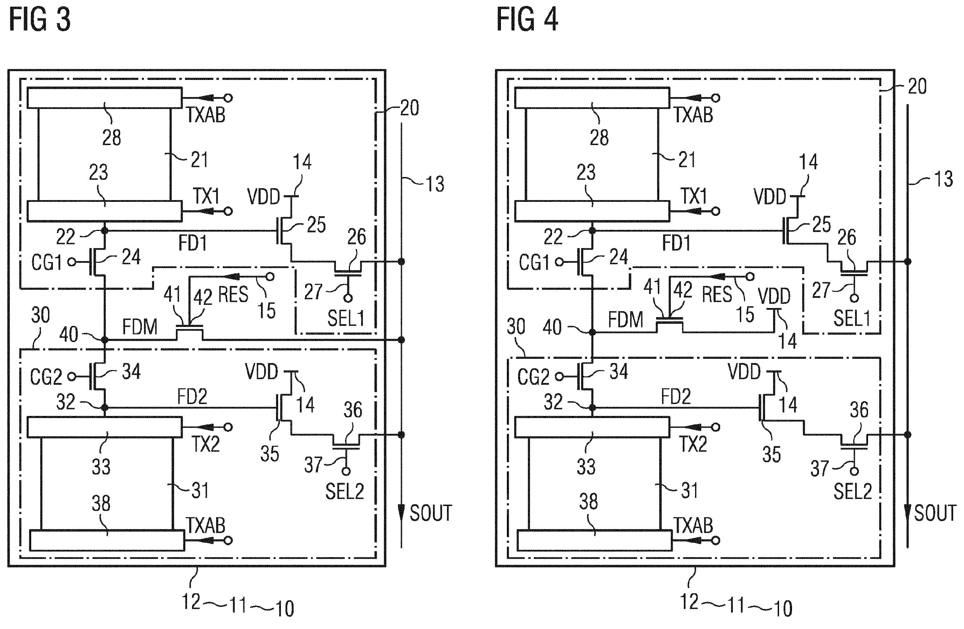

Figure 3 shows an exemplary embodiment of the image sensor 10 which is a further development of the above-shown embodiments. The first pixel 20 comprises a select transistor 26 that is arranged between the first terminal of the source follower transistor 25 of the first pixel 20 and the output bus 13. A control terminal of the select transistor 26 is connected to a first select line 27. Correspondingly, the second pixel 30 comprises a select transistor 36 that is arranged between the first terminal of the source follower transistor 35 of the second pixel 30 and the output bus 13. A control terminal of the select transistor 36 is connected to a second select line 37.

A first select signal SEL1 is provided to the control terminal of the select transistor 26 of the first pixel 20, whereas a second select signal SEL2 is applied to the control terminal of the select transistor 36 of the second pixel 30.

In Figure 3, the image sensor 10 is configured as a 2x1 shared rolling shutter pixel architecture with select transistors 26, 36. One advantage of this structure is that the manufacturing yield can be higher, since a defect in one pixel which keeps the sense node high will not generate a bad column, but only a bad pixel. Such bad pixel can be interpolated from neighbours while a defect column cannot always be corrected. The structure has multiple conversion gain capabilities. In Figures 3, 4 and 9, the source follower output of each pixel can be connected/disconnected to the output bus 13 by the select switches 26, 36 controlled by the first and the second select signals SEL1, SEL2. This change can be also applied to all rolling and global shutter variants as in Figures 1, 2 and 5 to 8.

Figure 4 shows a further exemplary embodiment of the image sensor 10 which is a further development of the image sensor shown in Figures 1 to 3. The single reset transistor 41 is arranged between the common reset node 40 and the supply line 14. The second terminal of the single reset transistor 41 may be directly and permanently connected to the supply line 14. Thus, in the reset phase, the single reset transistor 41 is set in a conducting state by the reset control signal RES and the supply voltage VDD is provided to the common reset node 40 and thus to the sense nodes 22, 32 of the first and the second pixels 20, 30.

In Figure 4, the image sensor 10 is implemented as a 2x1 shared rolling shutter pixel architecture with select transistor 26, 36 and reset to the supply voltage VDD. The first pixel 20 is realized such that the single reset transistor 41 is connected to the vertical supply line 14 which supplies the pixel source followers 25, 35, and a separate select line 27, 37. This circuit is designed to operate also in the three conversion gain modes as described above.

Advantageously, the output bus 13 does not have to be pulled up before readout which will reduce the time needed to sample the signal from a pixel such as the first pixel 20. The output bus 13 is realized as column bus. The first and the second pixel 20, 30 shown in Figures 3 and 4 are free from a global shutter gate.

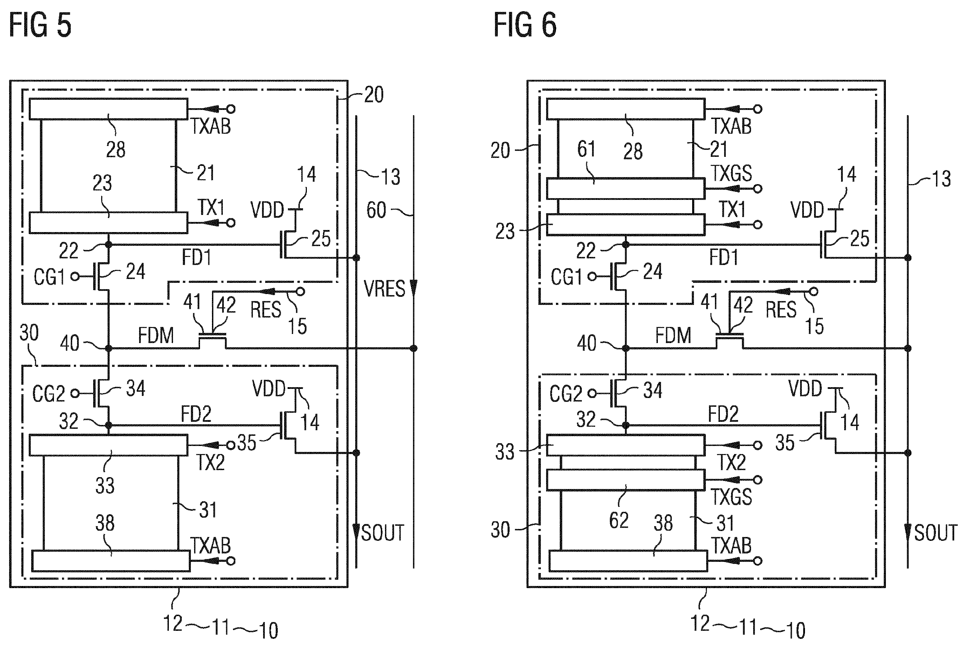

Figure 5 shows an additional exemplary embodiment of the image sensor 10 which is a further development of the above-shown embodiments. The array of pixels 11 comprises a reset bus 60. The single reset transistor 41 is arranged between the common reset node 40 and the reset bus 60. The second terminal of the single reset transistor 41 may be directly and permanently connected to the reset bus 60. The reset bus 60 is separated from the output bus 13.

The reset voltage VRES is applied to the reset bus 60. The reset bus 60 may continuously obtain the reset voltage VRES. Thus, the output bus 13 only has the function of providing the signal of one of the source follower transistors 25, 35 of one of the pixels 20, 30 to the output, since the potential used for resetting the pixels 20, 30 is provided via the reset bus 60. Advantageously, energy losses resulting from switching the output bus 13 to different voltage values or states are reduced.

In Figure 5, the image sensor 10 is configured as a 2x1 shared rolling shutter pixel architecture with separate reset bus 60. The reset voltage VRES is supplied by a separate signal bus that is the reset bus 60. This embodiment can be also applied to all rolling and global shutter variants as in the other Figures.

The use of the reset bus 60 results in an independent control of the reset voltage VRES and of the voltage applied to the floating diffusion during exposure.

In an alternative, not shown embodiment, the anti-blooming gates 28, 38 can be omitted in rolling shutter pixels, since excess charges can be drained away via the connection switches 24, 34 and the single reset transistor 41 to the reset bus 60. Thus, the use of the reset bus 60 also makes anti-blooming control easier. The reset bus 60 can be named reset bus line.

Figure 6 shows a further exemplary embodiment of the image sensor 10 which is a further development of the above-shown embodiments. The first pixel 20 comprises a global shutter gate 61 that is arranged between the pinned photodiode 21 and the transfer gate 23 of the first pixel 20. Correspondingly, the second pixel 30 comprises a global shutter gate 62 coupling the pinned photodiode 31 to the transfer gate 33 of the second pixel 30. The global shutter gate 61, 62 of each pixel 20, 30 is controlled by a global shutter signal TXGS.

Advantageously, the global shutter gate 61, 62 of the first and the second pixel 20, 30 allow a simultaneous and synchronized measurement of light applied to the pinned photodiode 21 of the first pixel 20 and to the pinned photodiode 31 of the second pixel 30.

In Figure 6, the image sensor 10 is configured as a 2x1 shared global shutter pixel architecture. The image sensor 10 is designed as a 2x1 shared charge domain global shutter pixel architecture.

The image sensor 10 is able to read out the first sense node signal FD1 with three different conversion gains (referred to as low, medium and high conversion gain). The first sense node signal FD1 can be named photodiode signal.

A noise reduction at the third conversion gain may be achieved by using the two source follower transistors 25, 35 in parallel.

Said architecture supports a 2:1 in-pixel binning (vertical) for monochrome or colorized (Bayer-patterned) pixel arrays, depending on the layout (location of the pinned photodiode 21 towards the pinned photodiode 32).

In low conversion gain mode and for monochrome arrays: the pinned photodiodes 21, 31 of the first and the second pixel 20, 30 are (vertical) neighbours.

In low conversion gain mode and for color arrays: the pinned photodiodes 21, 31 of the first and the second pixel 20, 30 are no (vertical) neighbours; a pinned photodiode of another 2x1 shared pixel is located in between. This may be the case if the array of pixels 11 is realized as a Bayer color array. For other color arrangements, the placement may be different.

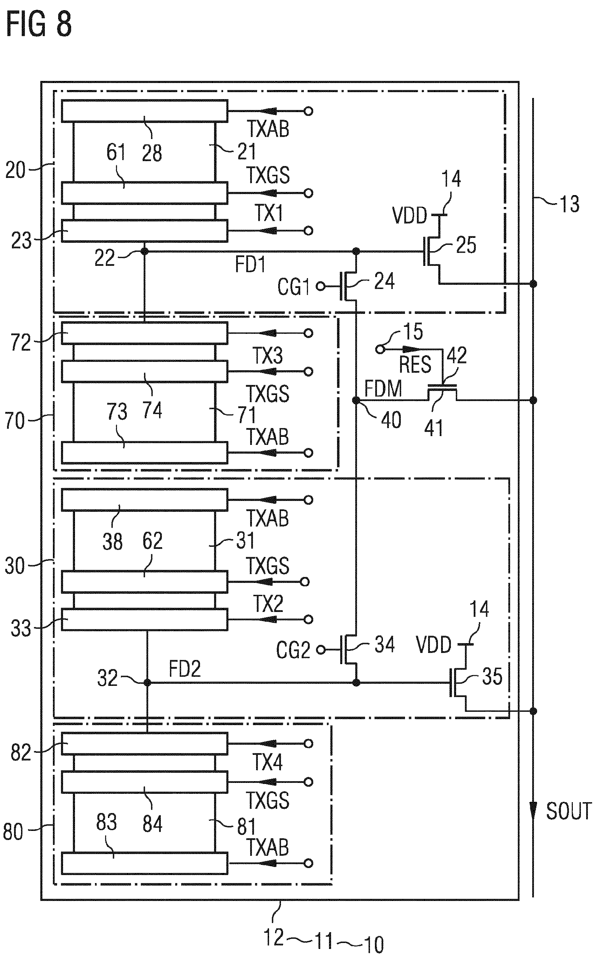

A benefit compared to other architectures e.g. shown in Figure 8 may be that the first conversion gain can be higher, since only a parasitic capacitance of one transfer gate 23 is connected to the sense node 22 resulting in lower read noise at low light conditions.

A not-shown reference potential line of the array of pixels 11 may provide a reference potential VSS to each subset of pixels 12.

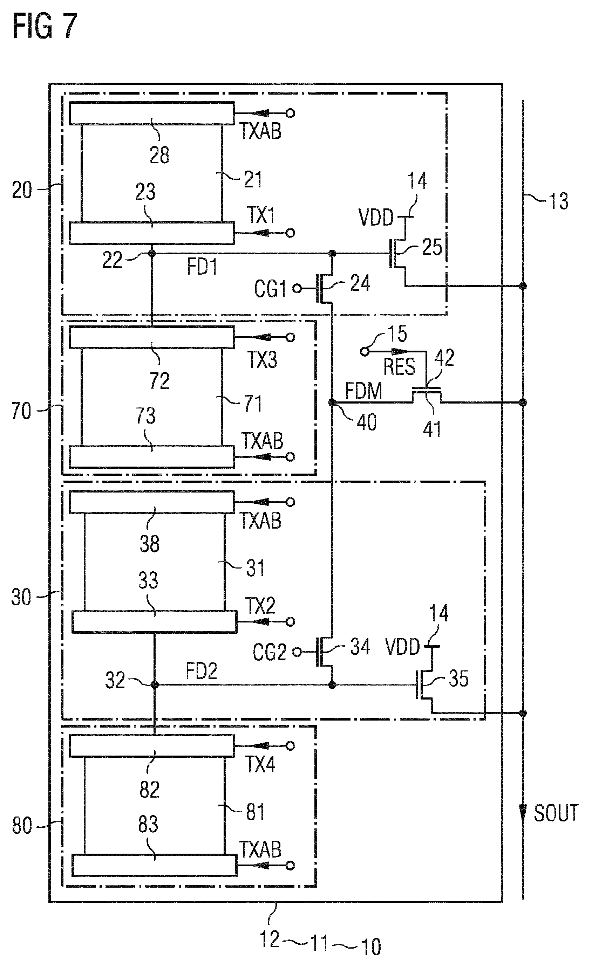

Figure 7 shows an exemplary embodiment of the image sensor 10 which is a further development of the above-shown embodiments. The subset of pixels 12 comprises a third pixel 70. The third pixel 70 comprises a pinned photodiode 71 and a transfer gate 72. The transfer gate 72 of the third pixel 70 couples the pinned photodiode 71 of the third pixel 70 to the sense node 22 of the first pixel 20. Moreover, the third pixel 70 comprises an anti-blooming gate 73 that is connected to the pinned photodiode 71 of the third pixel 70. The third pixel 70 is free from a source follower transistor and/or of a connection switch. The third pixel 70 uses the source follower transistor 25 and the connection switch 24 of the first pixel 20. The pinned photodiode 71 of the third pixel 70 provides its charge also to the sense node 22 of the first pixel 20. Thus, the first and the third pixel 20, 70 share the sense node 22, the source follower transistor 25 and the connection switch 24 of the first pixel 20.

Correspondingly, the subset of pixels 12 comprises a fourth pixel 80. The fourth pixel 80 comprises a pinned photodiode 81 and a transfer gate 82. The transfer gate 82 of the fourth pixel 80 couples the pinned photodiode 81 of the fourth pixel 80 to the sense node 32 of the second pixel 30. Moreover, the fourth pixel 80 comprises an anti-blooming gate 83 that is connected to the pinned photodiode 81 of the fourth pixel 80. The fourth pixel 80 is free from a source follower transistor and/or of a connection switch. The fourth pixel 80 uses the source follower transistor 35 and the connection switch 34 of the second pixel 30. The pinned photodiode 81 of the fourth pixel 80 provides its charge also to the sense node 32 of the second pixel 30. Thus, the second and the fourth pixel 30, 80 share the sense node 32, the source follower transistor 35 and the connection switch 34 of the second pixel 30.

In an integration phase or imaging phase for reading out the third pixel 70, the transfer gate 72 of the third pixel 70 is set in a conducting state by a third transfer signal TX3 such that a collected charge collected by the pinned photodiode 71 of the third pixel 70 is provided to the sense node 22 of the first pixel 20.

Advantageously, mainly in the case of a low illumination, the first and the third pixel 20, 70 may simultaneously provide charge to the sense node 22 of the first pixel 20. Thus, the first sense node signal FD 1 may be increased by the use of the third pixel 70.

The second and the fourth pixel 30, 80 can be combined during operation in a corresponding manner.

The image sensor 10 implements a 4x1 shared rolling shutter pixel architecture. The image sensor 10 realizes a rolling shutter variant of a 4:1 sharing architectures. A global reset operation of the photodiodes 21, 31, 71, 81 is performed by row-by-row or global reset by enabling the transfer gate 23 together with the connection switch 24 and the single reset transistor 41, while the output bus 13 is at the level of the supply voltage VDD.

Figure 8 shows a further exemplary embodiment of the image sensor 10 which is a further development of the above-shown embodiments. The image sensor 10 of Figure 8 is mainly a further development of the image sensor 10 shown in Figures 6 and 7. The first and the second pixel 20, 30 each comprises the global shutter gate 61, 62. Additionally, the third pixel 70 comprises a global shutter gate 74 that couples the pinned photodiode 71 to the transfer gate 72 of the third pixel 70. Correspondingly, the fourth pixel 80 comprises a global shutter gate 84 that couples the pinned photodiode 81 to the transfer gate 82 of the fourth pixel 80.

In Figure 8, the image sensor 10 is realized as a 4x1 shared global shutter pixel architecture. The image sensor 10 implements a 4x1 shared charge domain global shutter pixel architecture. This architecture supports:
- Readout of the first sense node signal FD1 is achieved with three different conversion gains (referred to as first, second and third conversion gain or low, medium and high conversion gain).
- The two source follower transistors 25, 35 can be used in parallel for noise reduction at low conversion gain.
- 2:1 in-pixel binning (vertical) for monochrome and colorized (Bayer-patterned) pixel arrays in the same electronic design: At monochrome arrays, binning is performed at high, medium and low conversion gain. At color arrays, binning can be realized at low conversion gain.
- 4:1 in-pixel binning (vertical) can be performed at low conversion gain.

Shutter operation is realized as:
- Global shutter
- Start of exposure (clear pinned photodiodes) by pulsing using the anti-blooming signal TXAB for each anti-blooming gate 28, 38 73, 83 in parallel (global).
- End of exposure (transfer charges to the sense nodes 22, 32) by pulsing the global shutter signal TXGS. The sense nodes 22, 32 are realized as memory nodes.

The readout operation is row-based. The readout operation differs for the three possible conversion gains:
A first or high conversion gain can be achieved by:
   Reading the first sense node signal FD1 of the pinned photodiode 21 (the sense node signals can be named pixel signals) is performed by:
      - Set the output bus 13 to the supply voltage VDD.
      - Reset the first sense node signal FD1 of the sense node 22 to the supply voltage VDD (column level) through the single reset transistor 41 and the connection switch 24 of the first pixel 20.
      - Hereon, the connection switch 24 of the first pixel 20 is set in a non-conducting state. Additionally, the single reset transistor 41 may also be set in a non-conducting state to reduce the load on the output bus 13.
      - Release the output bus 13 from the supply voltage VDD and apply bias current -> output bus 13 drops to a 'reset' value -> sample the 'reset' value in the readout structure 98 shown in Figure 10.
      - Pulse the transfer gate 23 of the first pixel 20 by the first transfer signal TX1 to transfer collected charges to the sense node 22 of the first pixel 20 -> the output bus 13 drops to a 'signal' value -> sample the 'signal' value in the readout structure 98.
      - De-select row by enabling the single reset transistor 41 and the connection switch 24, while keeping the output bus 13 biased (bias current might be increased to speed-up de-select operation).
      - Set the single reset transistor 41 and the connection switch 24 of the first pixel 20 in a low conducting state.

Furthermore, to read the pinned photodiode 71 of the third pixel 70 the same procedure is applied, but the third transfer signal TX3 is pulsed to transfer charges.
Additionally, to read the pinned photodiode 31 of the second pixel 30, the same procedure is applied, but the connection switch 34 of the second pixel 30 and the transfer gate 33 of the second pixel 30 are used. To read the pinned photodiode 81 of the fourth pixel 80 the same procedure is performed, but the connection switch 34 of the second pixel 30 and the transfer gate 82 of the fourth pixel 80 are used instead of the connection switch 24 of the first pixel 20 and the respective transfer gates 23, 33, 72.

A second or medium conversion gain is achieved by:
Reading the first sense node signal FD1 of the pinned photodiode 21 of the first pixel 20 is performed by:
   - Set the output bus 13 to the supply voltage VDD.
   - Set the connection switch 24 of the first pixel 20 in a conducting state.
   - Reset the first sense node signal FD1 and a common node signal FDM at the common node 40 to the supply voltage VDD (column level) through the single reset transistor 41.
   - Hereon, the single reset transistor 41 is set in a non-conducting state. The connection switch 24 of the first pixel 20 remains in the conducting state.
   - Release the output bus 13 from the supply voltage VDD and apply a bias current -> the output bus 13 drops to a 'reset' value -> sample the 'reset' value in the readout structure 98.
   - Pulse the first transfer signal TX1 to transfer collected charges to the sense node 22 of the first pixel 20 and the common reset node 40 -> the output bus 13 drops to a 'signal' value -> sample the 'signal' value in the readout structure 98.
   - De-select row by enabling the single reset transistor 41 by the reset control signal RES while keeping the output bus 13 biased (bias current might be increased to speed-up de-select operation).
   - Set the single reset transistor 41 and the connection switch 24 of the first pixel 20 in a non-conducting state.

Furthermore, to read the pinned photodiode 71 of the third photodiode 70, the same procedure is applied, but the third transfer signal TX3 is pulsed to transfer charges. Moreover, to read the pinned photodiodes 31, 81 of the second and the fourth pixel 30, 80, the same procedure is applied, but the second connection signal CG2 and the second and fourth transfer signals TX2, TX4 are used instead of the first connection signal CG1 and the first and third transfer signals TX1, TX3.

A low conversion gain can be achieved by the image sensor 10:
Reading the sense node signal FD1 of the pinned photodiode 21 is achieved by:
   - Set the output bus 13 to the supply voltage VDD.
   - Set the connection switches 24, 34 of the first and the second pixel 20, 30 in a conducting state.
   - Reset the sense nodes 22, 32 of the first and the second pixel 20, 30 and the common reset node 40 to the supply voltage VDD (column level) through the single reset transistor 41.
   - Hereon, the single reset transistor 41 is set in a non-conducting state. The connection switches 24, 34 of the first and the second pixel 20, 30 remain in the conducting state.
   - Release the output bus 13 from the supply voltage VDD and apply a bias current -> the output bus 13 drops to a 'reset' value -> sample the 'reset' value in the readout structure 98.
   - Pulse the first transfer signal TX1 to transfer collected charges to the common reset node 40 and the sense nodes 22, 32 of the first and the second pixel 20, 30 -> the output bus 13 drops to a 'signal' value -> sample 'signal' value in the readout structure 98.
   - De-select row by enabling the single reset transistor 41 while keeping the output bus 13 biased (bias current might be increased to speed-up de-select operation).
   - Set the single reset transistor 41 and both connection switches 24, 34 in a non-conducting state.

Additionally, to read the pinned photodiode 71 of the third pixel 70, the same procedure is performed, but the third transfer signal TX3 is pulsed to transfer charges.

Moreover, to read the pinned photodiodes 31, 81 of the second and the fourth pixel 30, 80, the same procedure is applied, but the second and fourth transfer signals TX2, TX4 are used instead of the first and third transfer signals TX1, TX3.

The binning operation is performed as follows in case of monochrome sensors:
- During read operation.
- Transfer charges of the pinned photodiodes 21, 71 of the first and the third pixel 20, 70 simultaneously by pulsing the first and the third transfer signals TX1, TX3 together in high, medium or low conversion gain mode (2:1 binning).
- Transfer charges of the four pinned photodiodes 21, 31, 71, 81 simultaneously by pulsing the first to the fourth transfer signals TX1 to TX4 together in low conversion gain mode (4:1 binning).

The binning operation is performed as follows in color sensors (e.g. with Bayer color filter pattern or any other pattern, where the pinned photodiodes 21, 31 of the first and the second pixel 20, 30 have the same color and the pinned photodiodes 71, 81 of the third and the fourth pixel 70, 80 have the same color):
- During read operation.
- Transfer charges of the pinned photodiodes 21, 31 of the first and the second pixel 20, 30 simultaneously by pulsing the first and the second transfer signals TX1, TX2 together in low conversion gain mode (2:1 binning).
- Transfer charges of the pinned photodiodes 71, 81 of the third and the fourth pixel 70, 80 simultaneously by pulsing the third and the fourth transfer signals TX3, TX4 together in low conversion gain mode (2:1 binning).

A noise reduction may be achieved by a low noise readout mode. In the low noise readout mode, the two source followers 25, 35 connected to the output bus 13 are connected in parallel which reduces the read noise. Thus, the source followers 25, 35 of the first and the second pixel 20, 30 are simultaneously set in the conducting state.

Advantageously, for best optical performance, the number of metal lines in the pixel or the subset of pixels 12 is kept low.

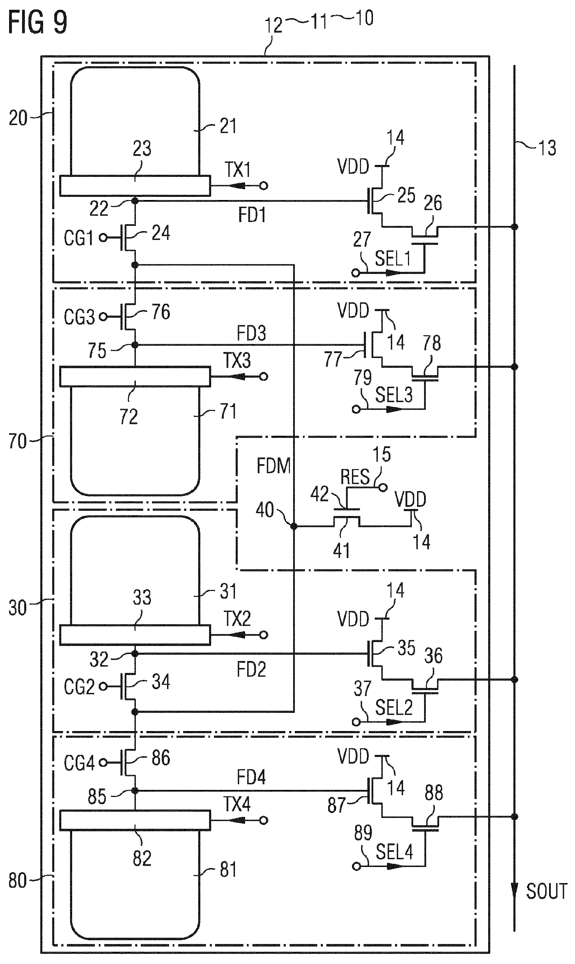

Figure 9 shows a further exemplary embodiment of the image sensor 10 which is a further development of the above-shown embodiments. The image sensor 10 of Figure 9 is mainly a further development of the image sensor 10 shown in Figures 1, 4 and 7.

The third pixel 70 comprises a sense node 75 and a connection switch 76. In the third pixel 70, the transfer gate 72 couples the pinned photodiode 71 to the sense node 75. The connection switch 76 of the third pixel 70 couples the sense node 75 of the third pixel 70 to the common reset node 40.

The third pixel 70 comprises a source follower transistor 77 that couples the sense node 75 of the third pixel 70 to the output bus 13. A select transistor 78 of the third pixel 70 is arranged between a first terminal of the source follower transistor 77 of the third pixel 70 and the output bus 13.

Correspondingly, the fourth pixel 80 comprises a sense node 85 and a connection switch 86. In the fourth pixel 80, the transfer gate 82 couples the pinned photodiode 81 to the sense node 85. The connection switch 86 of the fourth pixel 80 couples the sense node 85 of the fourth pixel 80 to the common reset node 40.

The fourth pixel 80 comprises a source follower transistor 87 that couples the sense node 85 of the fourth pixel 80 to the output bus 13. A select transistor 88 of the fourth pixel 80 is arranged between a first terminal of the source follower transistor 87 of the fourth pixel 80 and the output bus 13.

The image sensor 10 is configured to switch the conversion gain. The single reset transistor 41 is realized as a shared reset transistor per pixel. The first to the fourth pixel 20, 30, 70, 80 may be each free from an anti-blooming gate. Furthermore, the first to the fourth pixel 20, 30, 70, 80 may be each free from a global shutter gate.

The third pixel 70 has its own source follower transistor 77 and connection switch 76. The pinned photodiode 71 of the third pixel 70 provides its charge to its own sense node 75.

The subset of pixels 12 is configured to realize the first, second and third conversion gain which may be called low, medium and high conversion gain as described above. For the first, second and third conversion gain, the connection switches 76, 86 of the third and the fourth pixel 70, 80 are set in a non-conducting state.

The subset of pixels 12 may implement a fourth conversion gain that is lower than the third conversion gain. For the fourth conversion gain, the connection switch 76 of the third pixel 70 is set in a conducting state. The fourth conversion gain is achieved by setting the connection switches 24, 34, 76 of the first, the second and the third pixel 20, 30, 70 and the transfer gate 23 of the first pixel 20 in a conducting state. The single reset transistor 41 is set in the non-conducting state by the reset control signal RES. The connection switch 86 of the fourth pixel 80 is set in the non-conducting state.

In the fourth conversion gain, the charge collected by the pinned photodiode 21 of the first pixel 20 is provided to the sense nodes 22, 32, 75 of the first, the second and the third pixel 20, 30, 70 and to the common reset node 40. Thus, the collected charge is applied to four capacitors that are switched in parallel.

The subset of pixels 12 may realize a fifth conversion gain that is lower than the fourth conversion gain. For the fifth conversion gain, the connection switch 86 of the fourth pixel 80 is also set in a conducting state. The fifth conversion gain is achieved by setting the connection switches 24, 34, 76, 86 of the first to the fourth pixel 20, 30, 70, 80 and the transfer gate 23 of the first pixel 20 in the conducting state. The single reset transistor 41 is set in the non-conducting state by the reset control signal RES.

In the fifth conversion gain, the charge collected by the pinned photodiode 21 of the first pixel 20 is provided to the sense nodes 22, 32, 75, 85 of the first to the fourth pixel 20, 30, 70, 80 and to the common reset node 40. Thus, the collected charge is applied to five capacitors that are switched in parallel.

Thus, the image sensor 10 is designed to use each of the first to the fifth conversion gain. The first to the fifth conversion gain have five different values.

In an embodiment, the image sensor 10 is configured to realize only two conversion gains out of the set consisting of the first to the fifth conversion gain.

In an embodiment, the image sensor 10 is configured to realize only three conversion gains out of the set consisting of the first to the fifth conversion gain.

As shown in the above described Figures, an image sensor 10 comprises an array of pixels 11, composed of subsets of pixels 12, in which each pixel 20, 30, 70, 80 comprises:
- a pinned photodiode 21, 31, 71, 81,
- a transfer gate 23, 33, 72, 82, coupled to said pinned photodiode 21, 31, 71, 81 and coupled to a floating diffusion sense node 22, 32, 75, 85,
- a source follower transistor 25, 35, 77, 87 with its gate connected to said floating diffusion sense node 22, 32, 75, 85 and coupled to an output bus 13,
- a connection switch 24, 34, 76, 86 coupled to said floating diffusion sense node 22, 32, 75, 85 and to a common reset node 40 shared between two pixels 20, 30 or four pixels 20, 30, 70, 80,
- wherein each subset of pixels 12 has a reset control line 15 and wherein the common reset node 40 is connected by a reset transistor 41 to the reset bus 60, the output bus 13, the supply line 14 or a reset supply line in each subset of pixels 12.

In an embodiment, for example shown in Figure 2, the pixels 20, 30 comprise shared floating diffusions.

In an embodiment, for example shown in Figure 3, 4 and 9, the image sensor 10 comprises the select transistors 26, 36, 78, 88 and the select lines 27, 37, 79, 89.

In an embodiment, for example shown in Figure 6 and 8, the image sensor 10 realizes a global shutter configuration.

In an embodiment, for example shown in Figures 1, 2 and 5 to 8, in the structures avoiding the select transistors 26, 36 the single reset transistor 41 is connected to a vertical bus e.g. the output bus 13 or the reset bus 60 instead of the supply line 14. This allows to skip the select lines 27, 37 and the select transistors 26, 36.

In an embodiment, for example shown in Figures 1, 2, 3 and 6 to 8, the vertical bus is the pixel output bus 13. A terminal of the single reset transistor 41 is coupled to the output bus 13.

Figure 10 shows an exemplary embodiment of the image sensor 10 that is a further development of the above-shown embodiments. The image 10 comprises the array of pixels 11. The array of pixels 11 comprises N*M subsets of pixels 12, 90 to 97. The array of pixels 11 is organized in the number N of columns and the number M of rows. In the example shown in Figure 10, the number N and the number M are both 3.

Moreover, the image sensor 10 comprises the readout structure 98. The readout structure 98 is realized as a column output circuit. The output bus 13 couples the subsets of pixels 12, 90, 91 of a first column to the readout structure 98. Correspondingly, a further output bus 99 couples the subsets of pixels 92 to 94 of a second column to the readout structure 98. Furthermore, an additional output bus 100 couples the subsets of pixels 95 to 97 of a third column to the readout structure 98. Thus, the array of pixels 11 comprises multiple output busses 13, 99, 100. The supply line 14 is connected to each of the subsets of pixels 12, 90 to 97 for providing the supply voltage VDD to each of the subset of pixels 12, 90 to 97. Since the supply line 14 is split in several supply connection lines, the array of pixels 11 comprises multiple supply connection lines. One of the supply connection lines provides the supply voltage VDD to one column.

Additionally, the image sensor 10 comprises a control circuit 101 that is coupled to each of the subsets of pixels 12, 90 to 97. The subsets of pixels 12, 90 to 97 may be realized as shown in Figure 1. Then, the control circuit 101 generates the first and the second connection signal CG1, CG2, the first and the second transfer signal TX1, TX2 and the reset control signal RES which are provided to the subset of pixels 12. Correspondingly, the control circuit 101 generates the required control signals for the other subsets of pixels 90 to 97.

As explained above with reference to Figure 1, the reset voltage VRES is provided via the output bus 13 to the single reset transistor 41 in the reset phase. Thus, the control circuit 101 is coupled to the readout structure 98 for providing the reset voltage VRES to the output bus 13 in the reset phase.

Alternatively, the subsets of pixels 12, 90 to 97 may be realized as shown in Figures 2 to 9. The control circuit 101 generates the control signals as shown in these Figures.

In alternative, not shown, embodiments, the number N of columns may be less than 3 or more than 3. Also the number M of rows may be less than 3 or more than 3.

### Reference Numerals

- 10: image sensor
- 11: array of pixels
- 12: subset of pixels
- 13: output bus
- 14: supply line
- 15: reset control line
- 20: first pixel
- 21: pinned photodiode
- 22: sense node
- 23: transfer gate
- 24: connection switch
- 25: source follower transistor
- 26: select transistor
- 27: first select line
- 28: anti-blooming gate
- 30: second pixel
- 31: pinned photodiode
- 32: sense node
- 33: transfer gate
- 34: connection switch
- 35: source follower transistor
- 36: select transistor
- 37: second select line
- 38: anti-blooming gate
- 40: common reset node
- 41: single reset transistor
- 42: control terminal
- 60: reset bus
- 61, 62: global shutter gate
- 70: third pixel
- 71: pinned photodiode
- 72: transfer gate
- 73: anti-blooming gate
- 74: global shutter gate
- 75: sense node
- 76: connection switch
- 77: source follower transistor
- 78: select transistor
- 79: third select line
- 80: fourth pixel
- 81: pinned photodiode
- 82: transfer gate
- 83: anti-blooming gate
- 84: global shutter gate
- 85: sense node
- 86: connection switch
- 87: source follower transistor
- 88: select transistor
- 89: fourth select line
- 90 - 97: subset of pixels
- 98: readout structure
- 99, 100: output bus
- 101: control circuit
- CG1 - CG4: connection signal
- RES: reset control signal
- SEL1 - SEL4: select signal
- TXAB: anti-blooming signal
- TXGS: global shutter signal
- TX1 - TX4: transfer signal
- FD1 - FD4: sense node signal
- FDM: common node signal
- SOUT, SOUT', SOUT": output signal
- VRES: reset voltage
- VDD: supply voltage

## Claims

1. Image sensor comprising an array of pixels (11) having at least a subset of pixels (12),
wherein the subset of pixels (12) comprises a first and a second pixel (20, 30) such that each of the first and the second pixel (20, 30) comprises:
- a pinned photodiode (21, 31),
- a sense node (22, 32),
- a transfer gate (23, 33) coupled to the pinned photodiode (21, 31) and coupled to the sense node (22, 32), and
- a connection switch (24, 34) coupled to the sense node (22, 32), and
wherein the subset of pixels (12) further comprises
- a common reset node (40) such that the connection switch (24) of the first pixel (20) is coupled to the common reset node (40) and the connection switch (34) of the second pixel (30) is coupled to the common reset node (40), and
- a single reset transistor (41) which is configured to provide a reset voltage (VRES) to the common reset node (40), wherein the first and the second pixel (20, 30) share the single reset transistor (41).

2. Image sensor according to claim 1,
wherein the only controlled sections that are directly connected to the common reset node (40) are the controlled sections of the single reset transistor (41) and of the connection switches (24, 34).

3. Image sensor according to claim 1 or 2,
wherein the array of pixels (11) comprises an output bus (13) and a supply line (14), and each of the first and the second pixel (20, 30) comprises a source follower transistor (25, 35) having
- a gate connected to the sense node (22, 32),
- a first terminal coupled to the output bus (13) and
- a second terminal coupled to the supply line (14).

4. Image sensor according to claim 3,
wherein each of the first and the second pixel (20, 30) comprises a select transistor (26, 36) coupling the first terminal of the source follower transistor (25, 35) to the output bus (13).

5. Image sensor according to one of claims 1 to 4,
wherein a control terminal (42) of the single reset transistor (41) is the only control terminal comprised by the subset of pixels (12) that is configured to receive a reset control signal (RES).

6. Image sensor according to one of claims 1 to 5,
wherein the single reset transistor (41) comprises
- a first terminal coupled to the common reset node (40) and
- a second terminal coupled to one of a group comprising a reset bus (60), an output bus (13) and a supply line (14).

7. Image sensor according to one of claims 1 to 6,
wherein the subset of pixels (12) is free of a transistor, switch or gate connecting the common reset node (40) to one of a group comprising a reset bus (60), an output bus (13), a supply line (14) and a connecting line arranged between two common reset nodes besides the single reset transistor (41).

8. Image sensor according to one of claims 1 to 7,
wherein the sense nodes (22, 32) of the first and the second pixel (20, 30) and the common reset node (40) are realized as three separated floating diffusion sense nodes.

9. Image sensor according to one of claims 1 to 8,
wherein each of the first and the second pixel (20, 30) comprises a global shutter gate (61, 62) arranged between the pinned photodiode (21, 31) and the transfer gate (23, 33).

10. Image sensor according to one of claims 1 to 9,
wherein the image sensor (10) is configured to read out the first and the second pixel (20, 30) with at least two different conversion gains.

11. Image sensor according to claim 10,
wherein in a first conversion gain of the at least two different conversion gains, only the sense node (22) of the first pixel (20) receives a charge collected by the pinned photodiode (21) of the first pixel (20), and
in a second conversion gain of the at least two different conversion gains, only the sense node (22) of the first pixel (20) and the common reset node (40) receive the charge collected by the pinned photodiode (21) of the first pixel (21).

12. Image sensor according to one of claims 1 to 11,
wherein the subset of pixels (12) comprises a third and a fourth pixel (70, 80), each comprising a pinned photodiode (71, 81), a transfer gate (72, 82), a sense node (75, 85) and a connection switch (76, 86),
wherein the transfer gate (72) of the third pixel (70) couples the pinned photodiode (71) of the third pixel (70) to the sense node (75) of the third pixel (70) and the connection switch (76) of the third pixel (70) connects the sense node (75) of the third pixel (70) to the common reset node (40) and
wherein the transfer gate (82) of the fourth pixel (80) couples the pinned photodiode (81) of the fourth pixel (80) to the sense node (85) of the fourth pixel (80) and the connection switch (86) of the fourth pixel (80) connects the sense node (85) of the fourth pixel (80) to the common reset node (40).

13. Image sensor according to one of claims 1 to 11,
wherein the subset of pixels (12) comprises
- a third pixel (70) with a pinned photodiode (71) and a transfer gate (72) that couples the pinned photodiode (71) of the third pixel (70) to the sense node (22) of the first pixel (20) and
- a fourth pixel (80) with a pinned photodiode (81) and a transfer gate (82) that couples the pinned photodiode (81) of the fourth pixel (80) to the sense node (32) of the second pixel (30).

14. Method for operating an image sensor (10),
comprising
resetting a sense node (22) of a first pixel (20) and resetting of a sense node (32) of a second pixel (30) by switching a connection switch (24) of the first pixel (20), a connection switch (34) of the second pixel (30) and a single reset transistor (41) in a conducting state and providing a reset voltage (VRES) to a common reset node (40) by the single reset transistor (41),
wherein each of the first and the second pixel (20, 30) comprises a pinned photodiode (21, 31) and a transfer gate (23, 33) coupled to the pinned photodiode (21, 31) and to the sense node (22, 32),
wherein the connection switch (24) of the first pixel (20) couples the common reset node (40) to the sense node (22) of the first pixel (20), and the connection switch (34) of the second pixel (30) couples the common reset node (40) to the sense node (32) of the second pixel (30), and
wherein the single reset transistor (41) is coupled to the common reset node (40) and the first and the second pixel (20, 30) share the single reset transistor (41).
